# FASCICULE DE BREVET EUROPEEN

(11) **EP 4 184 579 B1**
(45) Date de publication et mention de la délivrance du brevet: **22.10.2025**
(21) Numéro de dépôt: 22207115.1
(22) Date de dépôt: 14.11.2022
(51) Int. Cl.: H10D 89/60, H02H 9/04

(54) **PROTECTION D'UN DOMAINE D'UN CIRCUIT INTÉGRÉ CONTRE DES SURTENSIONS**
SCHUTZ EINER DOMÄNE EINER INTEGRIERTEN SCHALTUNG GEGEN ÜBERSPANNUNGEN
OVERVOLTAGE PROTECTION OF AN INTEGRATED CIRCUIT DOMAIN

(30) Priorité: 18.11.2021 FR 2112211
(43) Date de publication de la demande: 24.05.2023
(73) Titulaire: STMicroelectronics (Alps) SAS, 38000 Grenoble (FR); STMicroelectronics (Grenoble 2) SAS, 38000 Grenoble (FR)
(72) Inventeur: MOENECLAEY, Nicolas, 38210 VOUREY (FR); PATRY, Jean-Luc, 38920 CROLLES (FR)
(74) Mandataire: Casalonga

(56) Documents cités:
- KR-A- 20080 062 530
- US-A1- 2011 304 940
- US-A1- 2012 112 286
- US-A1- 2016 336 308

## Description

Des modes de réalisation et de mise en œuvre concernent les circuits intégrés et notamment la protection d'au moins un domaine du circuit intégré contre des surtensions, en particulier au niveau des cellules d'entrée/sortie (I/O) du circuit intégré.

Les documents US2011/304940 A1, KR20080062530 A, US2016/336308 A1 et US2012/112286 A1 divulguent des circuits de protection contres les surtensions.

Des circuits intégrés tels que des microcontrôleurs prévoient généralement des cellules d'entrée/sortie permettant le transit de signaux entre l'extérieur du circuit intégré et un ou plusieurs domaines internes au circuit intégré.

Un domaine du circuit intégré peut être prévu pour fonctionner sous une première tension mais être capable de supporter une deuxième tension maximale, supérieure à la première.

Cela étant, il est possible que la cellule d'entrée/sortie reliée à ce domaine soit soumise au moins temporairement à une troisième tension supérieure à la deuxième tension.

Il existe par conséquent un besoin de protéger le plus efficacement possible ledit domaine contre ces surtensions.

Par ailleurs, certains circuits intégrés peuvent prévoir une cellule d'entrée/sortie haute vitesse («High speed I/O » en anglais) pour permettre une communication haute vitesse entre l'extérieur et ledit domaine. Plus particulièrement, ce type de cellule d'entrée/sortie doit par exemple être capable de faire transiter des signaux de hautes fréquences, de l'ordre de 12MHz à titre d'exemple, provenant d'un domaine du circuit intégré ou à destination de ce domaine.

Il existe donc également un besoin de proposer une solution permettant de protéger ce domaine contre des surtensions sans toutefois restreindre en fonctionnement la transmission de signaux hautes fréquences vers ou depuis ce domaine.

Selon un aspect, il est proposé à cet égard un circuit intégré comprenant au moins une cellule d'entrée/sortie ayant une première borne de signal pour recevoir/transmettre un signal et ayant une deuxième borne de signal connectée à un domaine configuré pour fonctionner sous une tension d'alimentation V0, par exemple 1,8 volts, et capable de supporter une tension maximale V1, par exemple 3,6 volts, supérieure à V0.

La cellule d'entrée/sortie comporte un réseau de N diodes, par exemple 4 diodes, connectées en série entre la deuxième borne de signal et un point froid d'alimentation, typiquement la masse, ledit réseau ayant une tension de seuil globale supérieure à V1.

Cette tension de seuil globale est égale à N fois la tension de seuil effective d'une diode, cette tension de seuil effective prenant en compte le fait que la diode comporte une résistance d'accès. Par exemple la tension de seuil effective d'une diode « réelle » peut être par exemple de l'ordre de 1,1 volt alors que la tension de seuil théorique d'une diode « idéale » (sans résistance d'accès) est typiquement de l'ordre de 0,7 volt.

La cellule d'entrée/sortie comporte également des moyens de commande connectés entre la première borne de signal et le réseau de diodes, et configurés pour, en présence d'une tension V2, par exemple 5 volts ou plus, sur la première borne de signal supérieure à la tension V1, court-circuiter automatiquement et de façon autonome au moins une des diodes de façon à limiter la tension sur la deuxième borne de signal à une valeur V3 inférieure à V1.

Par « des moyens de commande configurés pour court-circuiter automatiquement et de façon autonome au moins une des diodes », on entend que le court-circuit d'au moins une des diodes du réseau de diodes est réalisé sans intervention d'un signal d'activation de ces moyens de commande provenant d'un circuit externe à ces moyens de commande et ce même si la cellule d'entrée/sortie n'est pas alimentée, ce qui permet également d'assurer une protection contre les décharges électrostatiques (ESD : Electro Static Discharge). L'activation du mécanisme de court-circuit est ainsi avantageusement seulement conditionnée par la présence de la tension V2 sur la première borne de signal.

Par conséquent, la valeur de la tension V3 peut-être ainsi déterminée à partir de la somme des tensions de seuil effectives des diodes non-court-circuitées par les moyens de commande.

Selon un mode de réalisation, le nombre N est choisi de façon à limiter les fuites de courant entre la deuxième borne de signal et le point froid d'alimentation en deçà d'un seuil, par exemple 10 nA, lors du fonctionnement du domaine.

Ainsi par exemple, le nombre de diodes ne doit pas être trop faible pour limiter suffisamment le courant de fuite du domaine du circuit intégré lors de son fonctionnement.

L'homme du métier saura choisir le nombre N en fonction notamment des caractéristiques du domaine considéré du circuit intégré.

Selon l'invention, les moyens de commande comportent une première résistance connectée entre la première borne de signal et la deuxième borne de signal, un premier transistor PMOS dont la source et la grille sont respectivement connectées aux deux bornes de la première résistance et un deuxième transistor NMOS dont la grille est connectée au drain du premier transistor, dont la source est connectée au point froid d'alimentation par une deuxième résistance et dont le drain est connecté à un nœud du réseau de diodes situé entre deux diodes consécutives.

La première résistance permet d'avoir, en présence de la tension V2 sur la première borne de signal, une différence de potentiel à ces bornes conduisant à une tension grille source du premier transistor PMOS négative de façon à rendre passant ce premier transistor et d'avoir une tension grille source positive pour le deuxième transistor NMOS de façon à le rendre passant et court-circuiter ainsi le nombre désiré de diodes.

L'homme du métier saura ainsi choisir la valeur de la première résistance de façon à obtenir, en présence de la tension V2, une tension grille source du premier transistor PMOS supérieure en valeur absolue à la tension de seuil du premier transistor.

En outre, l'utilisation de transistors MOS et de résistances permet une réalisation simple des moyens de commande.

Selon un mode de réalisation, les moyens de commande comprennent en outre une troisième résistance connectée entre la première résistance et la première borne de signal, la source du premier transistor étant connectée au nœud commun à la première résistance et à la deuxième résistance.

L'ajout d'une troisième résistance dans les moyens de commande permet de réduire la tension entre la grille et la source du premier transistor grâce à un montage de type « pont diviseur », ce qui permet de protéger le premier transistor, notamment pour des valeurs élevées de tension V2.

Selon un mode de réalisation, les moyens de commande comprennent une quatrième résistance connectée entre le drain du premier transistor et la deuxième résistance, le grille du deuxième transistor étant connectée au nœud commun à la deuxième résistance et à la quatrième résistance.

L'ajout d'une quatrième résistance dans les moyens de commande permet de réduire la tension entre la grille et la source du deuxième transistor grâce à un montage de type « pont diviseur » ce qui permet également une protection du deuxième transistor, notamment pour des valeurs élevées de tension V2.

Selon un mode de réalisation, la cellule d'entrée/sortie comprend en outre un condensateur connecté entre la première borne de signal et la grille du deuxième transistor NMOS.

Il est en effet possible d'observer des variations brusques de tension V2 sur la première borne de signal et un dépassement de la valeur de tension maximale V1 assez rapide pour ne pas déclencher le mécanisme de court-circuit suffisamment rapidement. Le condensateur permet alors d'appliquer une tension sur la grille du deuxième transistor à partir de la tension V2 présente sur la première borne de signal pour activer le mécanisme très rapidement le mécanisme de court-circuit.

Cela étant, ce condensateur forme avec la première résistance, et éventuellement la troisième résistance, un filtre RC. L'homme du métier saura choisir la valeur capacitive du condensateur de façon à ne pas perturber la transmission de signaux haute vitesse et haute fréquence.

Selon un autre aspect, il est proposé un procédé de protection d'au moins un domaine d'un circuit intégré contre des surtensions, dans lequel le domaine fonctionne sous une tension d'alimentation V0, et est capable de supporter une tension maximale V1 supérieure à V0, et reçoit/transmet un signal via une première borne de signal d'une cellule d'entrée/sortie.

On connecte à l'intérieur de la cellule, entre une deuxième borne de signal connectée au domaine et un point froid d'alimentation, un réseau de N diodes en série, ledit réseau ayant une tension de seuil globale supérieure à V1, et en présence d'une tension V2 sur la première borne de signal supérieure à la tension V1, la cellule court-circuite elle-même automatiquement et de façon autonome au moins une des diodes de façon à limiter la tension sur la deuxième borne de signal à une valeur V3 inférieure à V1.

Selon un mode de mise en œuvre, le nombre N est choisi de façon à limiter les fuites de courant entre la deuxième borne de signal et le point froid d'alimentation en deçà d'un seuil lors du fonctionnement du domaine.

D'autres avantages et caractéristiques de l'invention apparaîtront à l'examen de la description détaillée de modes de réalisation et de mise en œuvre, nullement limitatifs, et des dessins annexés sur lesquels :
[Fig 1]
[Fig 2]
[Fig 3], et
[Fig 4] illustrent schématiquement des modes de mise en œuvre et de réalisation de l'invention.

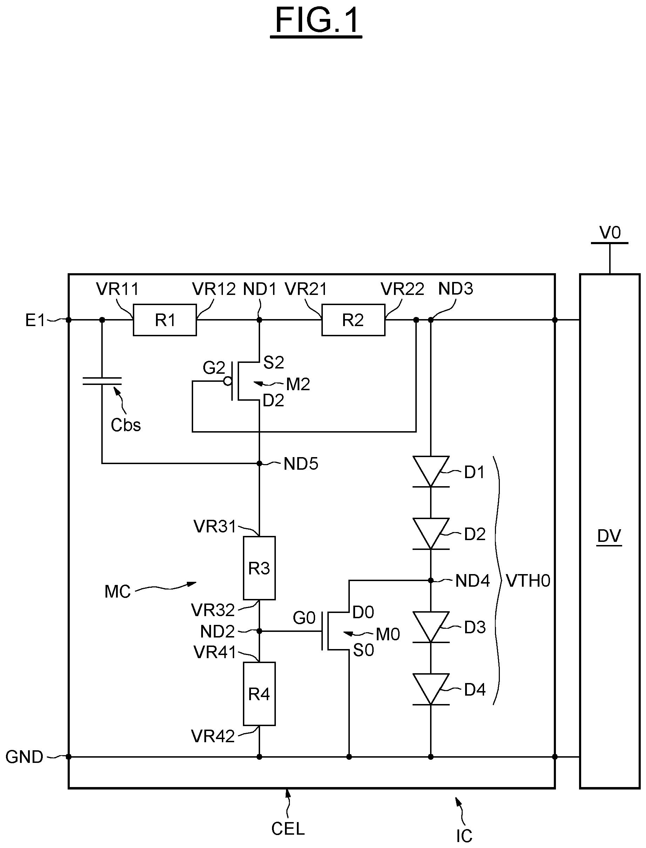

La figure 1 illustre un circuit intégré IC, par exemple un microcontrôleur qui comprend plusieurs cellules d'entrée/sortie dont une seule référencée CEL est représentée à des fins de simplification. Cette cellule CEL est connectée à un domaine DV du circuit intégré IC.

La cellule d'entrée/sortie CEL comprend une première borne de signal E1 et une deuxième borne de signal ND3, ainsi qu'un réseau de diodes.

La première borne de signal E1 permet de recevoir un signal provenant de l'extérieur du circuit IC ou de transmettre un signal depuis la cellule d'entrée/sortie CEL. Ce signal peut-être un signal carré ou un signal sinusoïdal par exemple ayant une fréquence définie, par exemple 12 Mhz. La tension V2 de ce signal est donc appliquée entre la première borne de signal E1 et un point froid d'alimentation GND. La deuxième borne de signal ND3 est connectée au domaine DV configuré ici pour fonctionner sous une tension d'alimentation V0, par exemple 1,8 volts.

Cela étant, le domaine DV est ici capable de supporter une tension maximale V1, par exemple 3,6 volts, supérieure à V0.

Le réseau de diodes peut comprendre N diodes, par exemple 4 diodes D1, D2, D3 et D4 connectées en série entre la deuxième borne de signal ND3 et un point froid d'alimentation GND, typiquement la masse, de la cellule CEL.

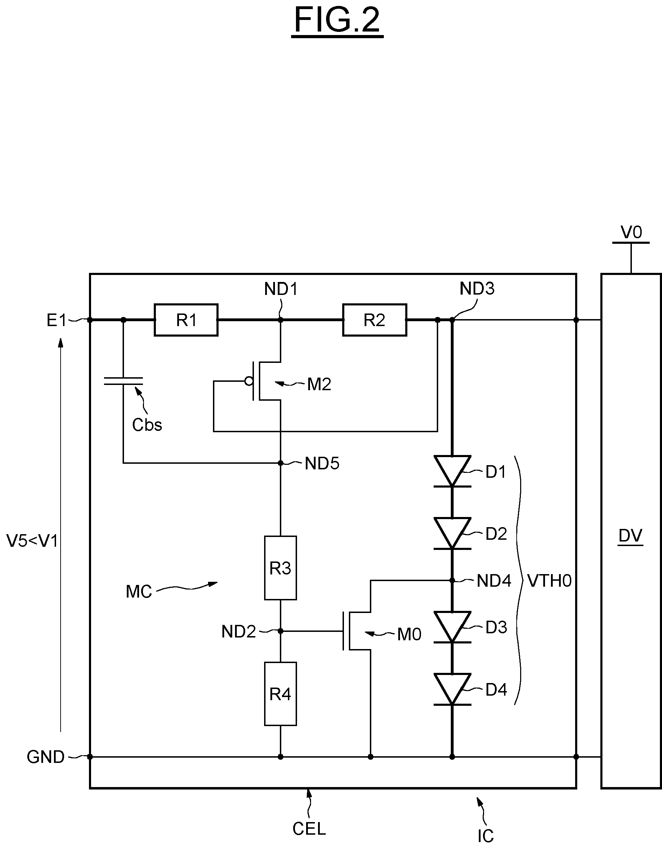

Le choix du nombre N de diodes peut dépendre des paramètres du circuit lors du fonctionnement du domaine DV et sera donc détaillé par la suite lors de la description de la figure 2.

Le réseau de diodes a une tension de seuil globale VTHO supérieure à V1 qui est ici égale à 4 (N=4) fois la tension de seuil effective d'une diode.

La tension de seuil effective prend en compte le fait qu'une diode comporte une résistance d'accès (non représentée sur la figure) et correspond donc à la tension de seuil « réelle » de la diode.

La tension de seuil « réelle » peut être par exemple de l'ordre de 1,1 volt alors que la tension de seuil théorique d'une diode, c'est-à-dire sans résistance d'accès, est typiquement de l'ordre de 0,7 volts. La tension de seuil globale VTHO du réseau de diodes peut alors valoir, en pratique, 4,4 volts au lieu de 2,8 volts en théorie.

La cellule d'entrée/sortie CEL comporte, en outre des moyens de commande MC connectés entre la première borne de signal E1 et le réseau de diodes.

Les moyens de commande MC comportent, dans ce mode de réalisation, une première résistance R2 et un premier transistor PMOS M2. La première résistance R2 est connectée indirectement entre la première borne de signal E1 et la deuxième borne de signal ND3. La première résistance R2 possède plus particulièrement une borne VR21 et une borne VR22 reliée à la deuxième borne de signal ND3. La source S2 et la grille G2 du premier transistor M2 sont respectivement connectées aux bornes VR21 et VR22 de la première résistance R2.

Ainsi, la tension Vgs2 entre la grille G2 et la source S2 du premier transistor M2 est égale à la différence de potentiel aux bornes de la première résistance R2. En fonction de la tension présente à la première borne de signal E1 et de la valeur de la résistance R2, la tension grille source Vgs2 du premier transistor PMOS M2 sera inférieure ou supérieure en valeur absolue à la tension de seuil du premier transistor M2 A titre d'exemple, la résistance R2 est ici égale à 113 Ohms.

Les moyens de commande comportent également un deuxième transistor NMOS M0 dont la grille G0 est connectée au drain D2 du premier transistor M2 et dont la source est connectée au point froid d'alimentation GND par une deuxième résistance R4. Le drain D0 du deuxième transistor M0 est connecté à un nœud du réseau de diodes situé entre deux diodes consécutives, par exemple le nœud ND4 situé entre les diodes D2 et D3.

Ainsi, la tension Vgs0 entre la grille G0 et la source S0 du deuxième transistor M0 est égale à la différence de potentiel aux bornes de la deuxième résistance R4. Selon que le transistor M2 est passant ou bloqué et en fonction de la valeur de la résistance R4, une tension grille source Vgs0 du deuxième transistor NMOS M0 sera inférieure ou supérieure en valeur absolue à la tension de seuil du deuxième transistor M0. A titre d'exemple, une résistance R4 est égale à 86000 Ohms.

En outre, les moyens de commande MC peuvent comporter, optionnellement, des troisièmes et quatrièmes résistances R1 et R3.

La troisième résistance R1 est connectée entre la première résistance R2 et la première borne de signal E1.

La troisième résistance R1 possède plus particulièrement une borne VR11 reliée à la première borne de signal E1 et une borne VR12 reliée à la borne VR21 de la première résistance R2.

Par ailleurs, la source S2 du premier transistor M2 est connectée au nœud commun ND1 à la première résistance R2 et à la troisième résistance R1.

La quatrième résistance R3 est connectée entre le drain D2 du premier transistor M2 et la deuxième résistance R4.

La quatrième résistance R3 possède plus particulièrement une borne VR31 reliée au drain D2 du premier transistor M2 et une borne VR32 reliée à la borne VR41 de la deuxième résistance R4.

Par ailleurs, la grille G0 du deuxième transistor M0 est connectée au nœud commun ND2 à la deuxième résistance R4 et à la quatrième résistance R3.

Les résistances R1 et R3 permettent d'abaisser respectivement la tension aux bornes de la résistance R2 et la tension aux bornes de la résistance R4 grâce à un montage de type « pont diviseur». Les valeurs des résistances R1 et R3 sont choisies de sorte à maintenir des tensions Vgs0 et Vgs2 suffisamment basses afin de protéger les transistors M0 et M2, notamment pour des valeurs élevées de tension V2 à la première borne de signal E1.

A titre d'exemple, on pourra choisir une résistance R1 de 48 Ohms et une résistance R3 de 86000 Ohms.

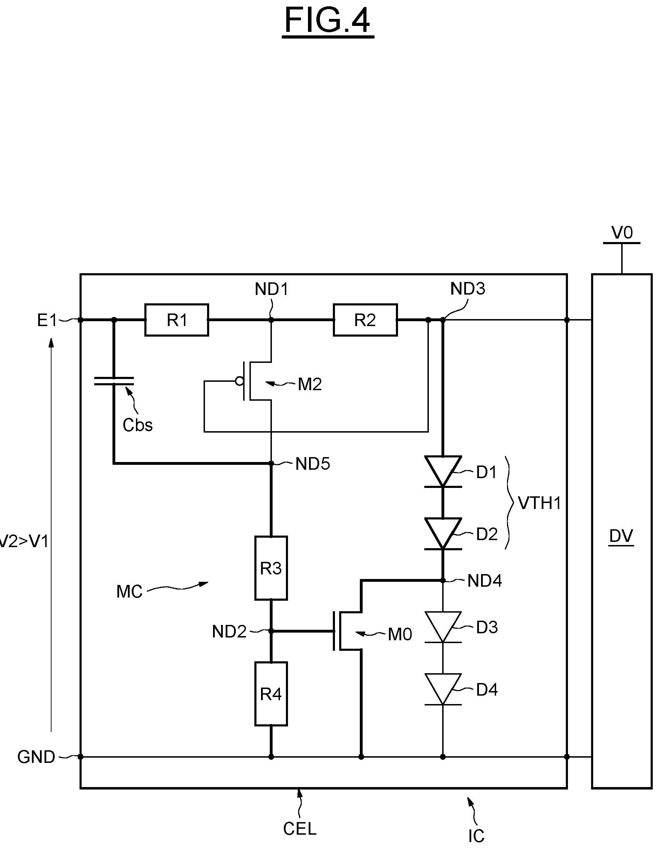

Les moyens de commande MC comprennent en outre un condensateur Cbs connecté entre la première borne de signal E1 et la grille G0 du deuxième transistor M0. Le fonctionnement du condensateur Cbs sera détaillé par la suite lors de la description de la figure 4.

Les figures 2 à 4 illustrent le circuit intégré IC décrit précédemment en relation avec la figure 1 pour différentes valeurs de tensions présentes à la première borne de signal E1.

La figure 2 illustre le fonctionnement du circuit IC lorsqu'une tension V5 inférieure à la tension maximale V1 supportée par le domaine DV, est présente à la première borne E1.

En présence d'une tension V5 sur la première borne de signal E1, les résistances R1 et R2 provoquent une chute de potentiel respectivement entre la première borne de signal E1 et le nœud commun ND1 et entre le nœud commun ND1 et la deuxième borne de signal ND3. La tension Vgs2 entre la grille G2 et la source S2 du premier transistor PMOS M2 est alors inférieure en valeur absolue à la tension de seuil du premier transistor PMOS M2. Par conséquent, le premier transistor M2 reste à l'état bloqué et ne laisse passer aucun courant entre la source S2 et le drain D2.

Le transistor M2 empêche le courant de passer dans les deuxièmes et quatrièmes résistances R4 et R3 et la différence de potentiel aux bornes de la résistance R4 est donc nulle. La tension grille source Vgs0 du deuxième transistor M0 est alors inférieure en valeur absolue à la tension seuil du deuxième transistor M0. Par conséquent, le transistor M0 est à l'état bloqué et ne laisse passer aucun courant entre le drain D0 et la source S0.

Autrement dit, le deuxième transistor M0 ne laisse passer aucun courant entre le nœud ND4 du réseau de diodes situé entre les diodes D2 et D3 et le point froid d'alimentation GND, et les diodes D3 et D4 ne sont donc pas court-circuitées par le deuxième transistor M0.

Le domaine DV voit une tension V3 au nœud ND3 inférieure à V1. Plus précisément, la tension V3 est inférieure à VTHO et les diodes D1, D2, D3 et D4 du réseau de diodes sont donc à l'état bloqué.

Cependant, il est connu qu'une diode, même à l'état bloqué, est susceptible de laisser passer un courant de fuite du fait de ses caractéristiques non-idéales. Le nombre N de diodes est alors choisi de façon à limiter les fuites de courant entre la deuxième borne de signal ND3 et le point froid d'alimentation GND en deçà d'un seuil, par exemple 10 nA, lors du fonctionnement du domaine DV. Par exemple, un nombre N de diodes trop faible permettra peut-être d'assurer un fonctionnement normal du domaine DV mais ne sera pas capable de limiter suffisamment le courant de fuite et entrainera alors une augmentation de la consommation électrique du circuit IC.

Ainsi, il est avantageux d'utiliser dans ce mode de réalisation 4 diodes D1, D2, D3 et D4 pour limiter les fuites de courant entre la deuxième borne de signal ND3 et le point froid d'alimentation GND en deçà de 10 nA.

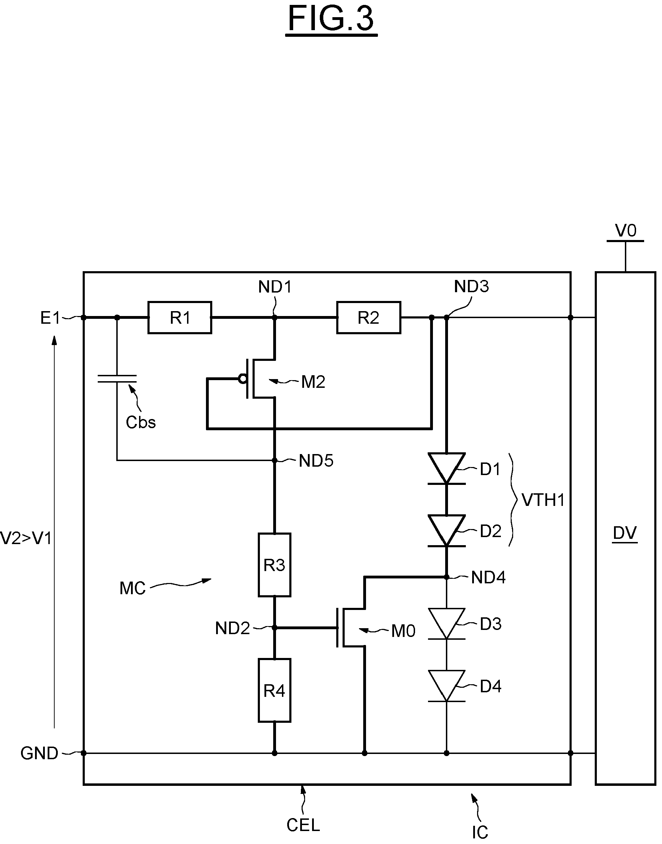

La figure 3 illustre le circuit IC lorsqu'une tension V2 supérieure à la tension maximale V1 supportée par le domaine DV, est présente à la première borne de signal E1.

En présence d'une telle tension V2, de 5,5 volts par exemple, sur la première borne de signal E1, les résistances R1 et R2 provoquent une chute de potentiel respectivement entre la première borne de signal E1 et le nœud commun ND1 et entre le nœud commun ND1 et la deuxième borne de signal ND3. On peut obtenir un potentiel de 4,44 volts sur le nœud commun ND1 et une différence de potentiel entre les bornes de la résistance R2 de 2,36 volts.

La tension Vgs2 entre la grille et la source du premier transistor PMOS M2, de même valeur que la différence de potentiel aux bornes de la résistance R2, devient alors supérieure en valeur absolue à la tension de seuil du premier transistor PMOS M2. Le transistor M2 passe alors de l'état bloqué à l'état passant et un courant peut circuler entre la source S2 et le drain D2. Une tension de 4,44 volts est alors présente au nœud ND5.

Le courant circulant entre la première borne de signal E1 et la deuxième borne de signal ND3 circule dans les deuxièmes et quatrièmes résistances R4 et R3 par l'intermédiaire du premier transistor M2, ce qui a pour effet d'augmenter la différence de potentiel entre les bornes des résistance R3 et R4. On peut obtenir une différence de potentiel entre les bornes de la résistance R4 de 2,22 volts, correspondant au potentiel sur le nœud commun ND2.

La tension Vgs0 entre la grille G0 et la source S0 du deuxième transistor NMOS M0, de même valeur que la différence de potentiel aux bornes de la résistance R4, devient alors supérieure en valeur absolue à la tension de seuil du deuxième transistor M0

Le transistor M0 passe à l'état passant et le courant au nœud ND4 du réseau de diodes situé entre les diodes D2 et D3 peut circuler entre le drain D0 et la source S0 du transistor M0, court-circuitant ainsi les diodes D3 et D4.

En conséquence, les diodes D1 et D2 deviennent passantes et le domaine DV voit une tension V3 entre la deuxième borne de signal ND3 et le point froid d'alimentation GND égale à la somme des tensions de seuil effectives VTH1 des diodes D1 et D2 non-court-circuitées par les moyens de commande. On peut ainsi obtenir un potentiel de 2,08 volts sur la deuxième borne de signal ND3, correspondant à la valeur réelle de la tension de seuil VTH1.

Cette tension VTH1 est inférieure à V1 (3,6 volts) et le domaine DV est par conséquent protégé.

La commutation du transistor M0 se produit du seul fait de la présence de la tension V2 qui se situe au-delà d'un seuil défini en fonction des caractéristiques des moyens de commande telles que les tensions de seuil des transistors M2 et M0 et les valeurs des résistances R1 à R4 préalablement déterminées par l'homme du métier.

De ce fait, les moyens de commande sont configurés pour court-circuiter automatiquement et de façon autonome les diodes D3 et D4 de façon à limiter la tension sur la deuxième borne de signal ND3 à une valeur V3 inférieure à la tension V1, et ce même en l'absence d'alimentation.

Néanmoins, dans certains cas, il est possible d'observer des variations brusques de la tension V2, en particulier pour des signaux de hautes fréquences.

La tension V2 peut alors dépasser la valeur de tension V1 sans que la commutation du premier transistor M2 n'ait le temps de se produire. Le mécanisme de court-circuit n'est donc plus capable de se déclencher suffisamment rapidement pour limiter la tension sur la deuxième borne de signal ND3 à une valeur V3 inférieure à la tension V1.

Le condensateur Cbs va permettre de remédier à ceci, comme illustré sur la figure 4.

En présence d'une tension V2, de 5,5 volts par exemple, sur la première borne de signal E1, le condensateur Cbs permet d'appliquer la tension V2 directement sur la grille G0 du deuxième transistor M0, (peu importe l'état du premier transistor M2) lorsque les moyens de commande MC comprennent uniquement une résistance R4.

Lorsque les moyens de commandes MC comprennent la quatrième résistance R3, le condensateur Cbs permet d'appliquer la tension V2 sur le nœud commun ND5 au transistor M2 et à la résistance R3.

Compte tenu des valeurs des résistances R3 et R4, on obtient, en présence de la tension V2 sur le nœud commun ND5, une tension grille source Vgs0 du deuxième transistor NMOS M0 supérieure en valeur absolue à la tension de seuil du deuxième transistor M0. Il en résulte donc une commutation du transistor M0 à l'état passant et un court-circuit des diodes D3 et D4.

Cependant, le condensateur Cbs forme un filtre RC passe-bas avec la résistance équivalente des résistances R1 et R2.

Les valeurs des résistances R1 et R2, ainsi que la capacité du condensateur Cbs sont donc déterminées en fonction de la fréquence du signal à faire transiter dans la cellule CEL afin de ne pas restreindre en fonctionnement la transmission de signaux hautes fréquences. Pour une fréquence du signal de 12 Mhz, on pourra choisir par exemple une capacité de 2 pF et les valeurs de résistance R1 et R2 citées précédemment.

La cellule d'entrée/sortie CEL offre donc une protection du domaine DV contre des surtensions, même en l'absence d'alimentation, puisque c'est la seule surtension présente à la première borne de signal E1 qui va déclencher le mécanisme de protection en court-circuitant un nombre choisi de diodes.

Dans l'exemple qui a été décrit, on obtient une protection efficace contre des surtensions allant de V1 (3,6 volts) jusqu'à une tension de 5,5 volts, et ce même en présence d'une variation rapide de tension sur la borne E1, tout en préservant un fonctionnement correct pour des signaux haute fréquence.

Les valeurs des différentes résistances, du condensateur Cbs et le nombre de diodes à court-circuiter seront déterminées par l'homme du métier lors de la conception de la cellule CEL en fonction de la tension V1 et de la plage de surtensions pour laquelle une protection est requise.

## Revendications

1. Circuit intégré (IC) comprenant au moins une cellule d'entrée/sortie (CEL) ayant une première borne de signal (E1) pour recevoir/transmettre un signal et ayant une deuxième borne de signal (ND3) connectée à un domaine (DV) configuré pour fonctionner sous une tension d'alimentation V0 et capable de supporter une tension maximale V1 supérieure à V0, dans lequel la cellule d'entrée/sortie (CEL) comporte un réseau de N diodes connectées en série entre la deuxième borne de signal (ND3) et un point froid d'alimentation (GND), ledit réseau ayant une tension de seuil globale supérieure à V1, et des moyens de commande (M0, M2) connectés entre la première borne de signal (E1) et le réseau de diodes et configurés pour, en présence d'une tension V2 sur la première borne de signal (E1) supérieure à la tension V1, court-circuiter automatiquement et de façon autonome au moins une des diodes (D3, D4) de façon à limiter la tension sur la deuxième borne de signal (ND3) à une valeur V3 inférieure à V1,
les moyens de commande comportant une première résistance (R2) connectée entre la première borne de signal (E1) et la deuxième borne de signal (ND3), un premier transistor PMOS (M2) dont la source (S2) et la grille (G2) sont respectivement connectées aux deux bornes de la première résistance (R2) et un deuxième transistor NMOS (M0) dont la grille (G0) est connectée au drain (D2) du premier transistor (M2), dont la source (S0) est connectée au point froid d'alimentation (GND) par une deuxième résistance (R4) et dont le drain (D0) est connecté à un nœud (ND4) du réseau de diodes situé entre deux diodes consécutives.

2. Circuit intégré selon la revendication 1, dans lequel le nombre N est choisi de façon à limiter les fuites de courant entre la deuxième borne de signal (ND3) et le point froid d'alimentation (GND) en deçà d'un seuil lors du fonctionnement du domaine (DV).

3. Circuit intégré selon la revendication 1 ou 2, dans lequel les moyens de commande comprennent en outre une troisième résistance (R1) connectée entre la première résistance (R2) et la première borne de signal (E1), la source du premier transistor (M2) étant connectée au nœud commun (ND1) à la première résistance (R2) et à la troisième résistance (R1).

4. Circuit intégré selon l'une des revendications 1 à 3, comprenant une quatrième résistance (R3) connectée entre le drain du premier transistor (M2) et la deuxième résistance (R4), le grille du deuxième transistor (M0) étant connectée au nœud commun (ND2) à la deuxième résistance (R4) et à la quatrième résistance (R3).

5. Circuit intégré selon l'une des revendications 1 à 4, dans lequel la cellule d'entrée/sortie (CEL) comprend en outre un condensateur (Cbs) connecté entre la première borne de signal (E1) et la grille du deuxième transistor NMOS (M0).

## Patentansprüche

1. Integrierte Schaltung (IC), umfassend mindestens eine Eingangs-/Ausgangszelle (CEL), die eine erste Signalklemme (E1) zum Empfangen/Übertragen eines Signals aufweist und eine zweite Signalklemme (ND3) aufweist, die mit einem Bereich (DV) verbunden ist, der so konfiguriert ist, dass er unter einer Versorgungsspannung V0 arbeitet und in der Lage ist, einer maximalen Spannung V1, die größer ist als V0, standzuhalten, wobei die Eingangs-/Ausgangszelle (CEL) ein Netz aus N Dioden umfasst, die in Reihe zwischen der zweiten Signalklemme (ND3) und einem kalten Versorgungspunkt (GND) geschaltet sind, wobei das Netz eine Gesamtschwellenspannung, die größer ist als V1, aufweist und Steuermittel (M0, M2) zwischen der ersten Signalklemme (E1) und dem Diodennetz verbunden und so konfiguriert sind, dass sie bei Vorhandensein einer Spannung V2 an der ersten Signalklemme (E1), die größer ist als die Spannung V1, automatisch und eigenständig mindestens eine der Dioden (D3, D4) kurzschließen, um die Spannung an der zweiten Signalklemme (ND3) auf einen Wert V3, der kleiner ist als V1, zu begrenzen,
wobei die Steuermittel einen ersten Widerstand (R2), der zwischen der ersten Signalklemme (E1) und der zweiten Signalklemme (ND3) verbunden ist, einen ersten PMOS-Transistor (M2), dessen Source (S2) und Gate (G2) jeweils mit den beiden Klemmen des ersten Widerstands (R2) verbunden sind, und einen zweiten NMOS-Transistor (M0) umfassen, dessen Gate (G0) mit dem Drain (D2) des ersten Transistors (M2) verbunden ist, dessen Source (S0) über einen zweiten Widerstand (R4) mit dem kalten Versorgungspunkt (GND) verbunden ist und dessen Drain (D0) mit einem Knoten (ND4) des Diodennetzes zwischen zwei aufeinanderfolgenden Dioden verbunden ist.

2. Integrierte Schaltung nach Anspruch 1, wobei die Anzahl N so gewählt ist, dass die Leckströme zwischen der zweiten Signalklemme (ND3) und dem kalten Versorgungspunkt (GND) unter einem Schwellenwert während des Betriebs des Bereichs (DV) begrenzt werden.

3. Integrierte Schaltung nach Anspruch 1 oder 2, wobei die Steuermittel ferner einen dritten Widerstand (R1) umfassen, der zwischen dem ersten Widerstand (R2) und der ersten Signalklemme (E1) verbunden ist, wobei die Source des ersten Transistors (M2) mit dem gemeinsamen Knoten (ND1) an dem ersten Widerstand (R2) und an dem dritten Widerstand (R1) verbunden ist.

4. Integrierte Schaltung nach einem der Ansprüche 1 bis 3, umfassend einen vierten Widerstand (R3), der zwischen dem Drain des ersten Transistors (M2) und dem zweiten Widerstand (R4) verbunden ist, wobei das Gate des zweiten Transistors (M0) mit dem gemeinsamen Knoten (ND2) an dem zweiten Widerstand (R4) und an dem vierten Widerstand (R3) verbunden ist.

5. Integrierte Schaltung nach einem der Ansprüche 1 bis 4, wobei die Eingangs-/Ausgangszelle (CEL) ferner einen Kondensator (Cbs) umfasst, der zwischen der ersten Signalklemme (E1) und dem Gate des zweiten NMOS-Transistors (M0) verbunden ist.

## Claims

1. An integrated circuit (IC) comprising at least one input/output cell (CEL) having a first signal terminal (E1) for receiving/transmitting a signal and having a second signal terminal (ND3) connected to a domain (DV) configured to operate under a supply voltage V0 and capable of withstanding a maximum voltage V1 greater than V0, wherein the input/output cell (CEL) includes an array of N diodes connected in series between the second signal terminal (ND3) and a supply cold point (GND), said network having a global threshold voltage greater than V1, and control means (M0, M2) connected between the first signal terminal (E1) and the array of diodes and configured to, in the presence of a voltage V2 on the first signal terminal (E1) greater than the voltage V1, automatically and autonomously short-circuit at least one of the diodes (D3, D4) so as to limit voltage on the second signal terminal (ND3) to a value V3 lower than V1,
the control means including a first resistor (R2) connected between the first signal terminal (E1) and the second signal terminal (ND3), a first PMOS transistor (M2) the source (S2) and the gate (G2) of which are respectively connected to the two terminals of the first resistor (R2) and a second NMOS transistor (M0) the gate of which is connected to the drain (D2) of the first transistor (M2), the source of which (S0) is connected to the cold supply point (GND) by a second resistor (R4) and the drain (D0) of which is connected to a node (ND4) of the array of diodes located between two consecutive diodes.

2. The integrated circuit according to claim 1, wherein the number N is chosen so as to limit current leakages between the second signal terminal (ND3) and the supply cold point (GND) below a threshold during operation of the domain (DV).

3. The integrated circuit according to claim 1 or 2, wherein the control means further comprise a third resistor (R1) connected between the first resistor (R2) and the first signal terminal (E1), the source of the first transistor (M2) being connected to the common node (ND1), to the first resistor (R2) and to the third resistor (R1).

4. The integrated circuit according to one of claims 1 to 3, comprising a fourth resistor (R3) connected between the drain of the first transistor (M2) and the second resistor (R4), the gate of the second transistor (M0) being connected to the common node (ND2), to the second resistor (R4) and to the fourth resistor (R3).

5. The integrated circuit according to one of claims 1 to 4, wherein the input/output cell (CEL) further comprises a capacitor (Cbs) connected between the first signal terminal (E1) and the gate of the second NMOS transistor (M0).
